# EUROPÄISCHE PATENTSCHRIFT

(11) **EP 1 697 966 B1**
(45) Veröffentlichungstag und Bekanntmachung des Hinweises auf die Patenterteilung: **13.02.2013**
(21) Anmeldenummer: 04802856.7
(22) Anmeldetag: 02.12.2004
(51) Int. Cl.: H01L 21/98, H01L 23/10, H01L 21/50, H01L 21/60

(54) **VERFAHREN ZUR WECHSELSEITIGEN KONTAKTIERUNG VON ZWEI WAFERN**
METHOD FOR THE MUTUAL CONTACTING OF TWO WAFERS
PROCEDE POUR METTRE DEUX TRANCHES DE SEMI-CONDUCTEUR EN CONTACT MUTUEL

(30) Priorität: 03.12.2003 DE 10357027; 23.12.2003 DE 10361521
(43) Veröffentlichungstag der Anmeldung: 06.09.2006
(60) Teilanmeldung: 09008647.1
(73) Patentinhaber: Pac Tech - Packaging Technologies GmbH, 14641 Nauen (DE)
(72) Erfinder: ZAKEL, Elke, 14641 Nauen (DE); AZDASHT, Ghassem, 13591 Berlin (DE)
(74) Vertreter: Tappe, Hartmut
(86) Internationale Anmeldenummer: PCT/DE2004/002648
(87) Internationale Veröffentlichungsnummer: WO 2005/055288

(56) Entgegenhaltungen:
- EP-A- 1 346 949
- DE-A1- 4 234 342
- DE-A1- 19 751 487
- TAO Y ET AL: "INVESTIGATION OF LASER-ASSISTED BONDING FOR MEMS PACKAGING" INTERNATIONAL JOURNAL OF NONLINEAR SCIENCE AND NUMERICAL SIMULATION, FREUND PUNLISHING HOUSE, TEL-AVIV, IL, Bd. 3, Nr. 3/4, 11. August 2002 (2002-08-11), Seiten 427-431, XP009023464 ISSN: 1565-1339
- MESCHEDER U M ET AL: "Local laser bonding for low temperature budget" SENSORS AND ACTUATORS A, ELSEVIER SEQUOIA S.A., LAUSANNE, CH, Bd. 97-98, 1. April 2002 (2002-04-01), Seiten 422-427, XP004361631 ISSN: 0924-4247

## Beschreibung

Die vorliegende Erfindung betrifft ein Verfahren zur wechselseitigen Kontaktierung von zwei waferartigen Bauelement-Verbundanordnungen aus einer Vielzahl zusammenhängend ausgebildeter gleichartiger Bauelemente, die nachfolgend vereinfacht als Wafer bezeichnet werden, insbesondere eines Halbleiter-Wafers mit einem Funktionsbauelement-Wafer, zur Herstellung von elektronischen Baugruppen auf Wafer-Ebene nach dem Oberbegriff der Ansprüchs 1.

Das Verfahren der vorgenannten Art kommt ganz allgemein dann zur Anwendung, wenn es darum geht, in einem Verbund zusammenhängend ausgebildete Substrate mit ebenfalls in einem Verbund angeordneten Bauelementen ohne vorhergehende Auflösung des jeweiligen Verbunds miteinander zu verbinden.

Zur Herstellung elektronischer Baugruppen auf Chipebene ist es bekannt, Chips bzw. Chipmodule mit den über die Chips angesteuerten Funktionsbauelementen, wie beispielsweise eine Laserdiode, sowohl den Chip als auch die Laserdiode auf Wafer-Ebene, also in einem zusammenhängenden Wafer-Verbund herzustellen und anschließend vor Kontaktierung des Chips mit der Laserdiode sowohl den Chip als auch die Laserdiode aus dem jeweiligen Wafer-Verbund zu vereinzeln. Hieraus ergibt sich die Notwendigkeit, einen zur Kontaktierung des Chips mit der Laserdiode notwendigen Positionierungs- und Verbindungsvorgang entsprechend der Anzahl der Chips bzw. der Laserdioden separat und wiederholt durchzuführen.

Je nach Art und Ausführung des für die Kontaktierung mit dem Chip vorgesehenen Funktionsbauelements erweist es sich überdies noch als erforderlich, ein Kontaktierungsverfahren sicherzustellen und entsprechend zu überwachen, bei dem die Temperaturbelastung des Funktionsbauelements in vorgegebenen Grenzen bleibt. Diese Grenzen sind insbesondere bei sehr temperaturanfälligen Funktionsbauelementen, wie beispielsweise Kunststoffmikrolinsen, sehr niedrig, so dass bei jedem einzelnen Kontaktierungsvorgang zwischen dem Chip und dem Funktionsbauelement für eine Begrenzung der bei dem Kontaktierungsvorgang im Funktionsbauelement erreichten Temperatur, beispielsweise durch entsprechende Kühlmaßnahmen, zu sorgen ist.

Aus: Yi Tao et al., "Investigation of Laser-assisted Bonding for MEMS packaging" International Journal of Nonlinear Sciences 3, 427-431, 2002 ist ein Verfahren bekannt, bei dem eine einzelne Laserquelle eingesetzt wird, die möglichst fein fokussiert wird, um eine übermäßige thermische Beanspruchung der Bauelemente einer Bauelemente-Verbundanordnung beim Bonden zu vermeiden. Aufgrund der Verwendung einer einzelnen, fein fokussierten Laserstrahlung ist es zum Bonden sämtlicher Kontaktpaarungen der Wafer notwendig, die einzelnen Kontaktpaarungen sequentiell mit Laserstrahlung zu beaufschlagen.

Aufs der DE-A-42 34 342 ist ein Verfahren zur Materialbearbeitung mit Laserstrahlung bekannt, bei dem Hochleistungsdioden eingesetzt werden, die im Verbund betrieben werden, um durch eine geeignete Bündelung der von den einzelnen Laserdioden emittierten Strahlung eine Gesamtstrahlung mit erhöhter Intensität zu erzeugen, um auf dem zu bearbeitenden Material eine entsprechend hohe Leistungsdichte auszubilden.

Der vorliegenden Erfindung liegt die Aufgabe zugrunde, eine gleichzeitige Beaufschlagung von sämtlichen oder in Gruppen zusammengefassten Kontaktpaarungen mit Laserstrahlung zu ermöglichen, ohne auch bei temperaturempfindlichen Funktionsbauelementen eine zulässige Temperaturbelastung zu überschreiten.

Zur Lösung dieser Aufgabe weist das erfindungsgemäße Verfahren eine Verbundanordnung von mehreren Diodenlasern auf, die einzeln oder in Gruppen zusammengefasst zur Emission von Laserstrahlung aktiviert werden, derart, dass sämtliche oder in Gruppen zusammengefasste Kontaktpaarungen zur Kontaktierung mit Laserstrahlung beaufschlagt werden.

Der vorliegenden Erfindung liegt nun die Aufgabe zugrunde, eine Herstellung entsprechender elektronischer Baugruppen auf Wafer-Ebene zu ermöglichen und darüber hinaus sicherzustellen, dass auch bei temperaturempfindlichen Funktionsbauelementen eine zulässige Temperaturbelastung nicht überschritten wird.

Zur Lösung dieser Aufgabe weist das erfindungsgemäße Verfahren die Merkmale des Anspruchs 1 auf.

Bei dem Verfahren werden die beiden jeweils auf ihren einander gegenüberliegenden Kontaktoberflächen mit Kontaktmetallisierungen versehenen Wafer zur Ausbildung von Kontaktpaarungen mit ihren Kontaktmetallisierungen in eine Überdeckungslage gebracht, in der die miteinander zu verbindenden Kontaktmetallisierungen gegeneinander gedrückt werden. Die Kontaktierung der Kontaktmetallisierungen erfolgt durch eine rückwärtige Beaufschlagung des einen Wafers mit Laserstrahlung, wobei die Wellenlänge der Laserstrahlung in Abhängigkeit vom Absorptionsgrad des rückwärtig beaufschlagten Wafers so gewählt wird, dass eine Transmission der Laserstrahlung durch den rückwärtig beaufschlagten Wafer im Wesentlichen unterbleibt.

Hierdurch wird sichergestellt, dass eine Erwärmung des mit dem ersten Wafer zu kontaktierenden zweiten Wafers im Wesentlichen über die Kontaktpaare bildenden Kontaktmetallisierungen erfolgt und eine unmittelbare Beaufschlagung des zweiten Wafers durch die Laserstrahlung unterbleibt.

Der durch die Kontaktierung der beiden Wafer geschaffene Waferverbund kann nachfolgend durch Vereinzelung in vereinzelte elektronische Baugruppen bestehend aus einem Chip und einem damit kontaktierten Funktionsbauelement aufgelöst werden.

Erfindungsgemäß erfolgt die Laserbeaufschlagung mittels einer Verbundanordnung von mehreren Diodenlasern, die einzeln oder in Gruppen zusammengefasst zur Emission von Laserstrahlung aktiviert werden, derart, dass sämtliche oder in Gruppen zusammengefasste Kontaktpaarungen zur Kontaktierung mit Laserstrahlung beaufschlagt werden.

Zum einen ermöglicht die Verwendung von Laserdioden zur Laserbeaufschlagung des Wafers eine besonders exakte Einstellbarkeit der von der laseraktiven Schicht des Diodenlasers emittierten Wellenlänge, so dass ein entsprechend hoher Absorptionsgrad im rückwärtig beaufschlagten Wafer erreichbar ist. Zum anderen ermöglicht die definierte Aktivierung ausgewählter Diodenlaser aus einer Verbundanordnung eine Laserbeaufschlagung gerade in dem Umfang, wie er zur Kontaktierung benötigt wird. In entsprechender Weise wird der rückwärtig beaufschlagte Wafer nur soweit erwärmt, wie es zur Kontaktierung unbedingt notwendig ist. Damit reduziert sich auch ein möglicher Wärmestrahlungsübergang von dem durch Absorption aufgeheizten ersten Wafer auf den gegenüberliegend zur Kontaktierung vorgesehenen zweiten Wafer.

Wenn die rückwärtig mit Laserstrahlung beaufschlagte Bauelement-Verbundanordnung so gewählt wird, dass eine Transmission der Laserstrahlung durch die rückwärtig mit Laserstrahlung beaufschlagte Bauelement-Verbundanordnung erfolgt und eine Absorption der Laserstrahlung im Wesentlichen lediglich in den Kontaktmetallisierungen der rückwärtig mit Laserstrahlung beaufschlagten Bauelement-Verbundanordnung erfolgt, ist es möglich, die für die Kontaktierung, die grundsätzlich bei dem Verfahren durch Thermokompression oder auch Aushärtung eines Klebers oder andere mögliche Verbindungsarten erfolgen kann, die zur Aktivierung einen Wärmeeintrag benötigen, notwendige Erwärmung der Kontaktmetallisierungen durch eine im Wesentlichen unmittelbare Erwärmung der Kontaktmetallisierungen durchzuführen. Insbesondere dann, wenn die Kontaktmetallisierungen der rückwärtig mit Laserstrahlung beaufschlagten Bauelement-Verbundanordnung aus einem Material gewählt sind, das eine im Vergleich zum Substratmaterial der gegenüberliegend angeordneten Bauelement-Verbundanordnung höhere Wärmekapazität aufweist, kann erreicht werden, dass die für die Kontaktierung erforderliche Temperaturerhöhung im Wesentlichen nur im Bereich der Kontaktmetallisierungen erfolgt.

Ein gleichzeitiger Wärmeeintrag in die Kontaktmetallisierungen der rückwärtig mit Laserstrahlung beaufschlagten Bauelement-Verbundanordnung und die Kontaktmetallisierungen der gegenüberliegend angeordneten Bauelement-Verbundanordnung kann erfolgen, wenn die rückwärtig mit Laserstrahlung beaufschlagte Bauelement-Verbundanordnung so gewählt wird, dass eine Transmission der Laserstrahlung durch die rückwärtig mit Laserstrahlung beaufschlagte Bauelement-Verbundanordnung erfolgt und eine Absorption der Laserstrahlung in den Kontaktmetallisierungen der rückwärtig mit Laserstrahlung beaufschlagten Bauelement-Verbundanordnung und in den im Vergleich zu den Kontaktmetallisierungen der rückwärtig mit Laserstrahlung beaufschlagten Bauelement-Verbundanordnung flächenmäßig größeren Kontaktmetallisierungen der gegenüberliegenden Bauelement-Verbundanordnung erfolgt.

Wenn die Diodenlaser-Verbundanordnung als Diodenlaser-Linearanordnung ausgebildet ist, die mit Abstand unterhalb des rückwärtig mit Laserstrahlung beaufschlagten Wafers angeordnet ist, derart, dass die Diodenlaser-Linearanordnung zumindest einachsig und parallel zur Erstreckungsebene des Wafers verfahren wird, ist das erfindungsgemäße Verfahren mittels einer relativ geringen Anzahl von Diodenlasern durchführbar.

Alternativ ist es möglich, die Diodenlaser- Verbundanordnung als Diodenlaser-Matrixanordnung auszubilden, wobei die Diodenlaser entsprechend der Größe des rückwärtig mit Laserstrahlung zu beaufschlagenden Wafers in ihrer Gesamtheit oder nur im Umfang einer Teilmatrix aktiviert werden. Diese Verfahrensvariante ermöglicht die gleichzeitige Kontaktierung aller Kontaktpaarungen, so dass die Kontaktierung auf Wafer-Ebene unter minimaler Temperaturbelastung für den weiteren Wafer innerhalb kürzester Zeit durchführbar ist.

Wenn in einem durch den Abstand zwischen dem rückwärtig beaufschlagten Wafer und der Diodenlaser-Verbundanordnung gebildeten Zwischenraum mittels einer von der Laserstrahlung durchdrungenen Transmissionseinrichtung eine Referenztemperatur gemessen wird, ist es möglich, fortlaufend während der Laserbeaufschlagung die Temperatur im rückwärtig beaufschlagten Wafer zu überwachen, um beispielsweise bei Erreichen eines Temperaturschwellwertes die Diodenlaser-Verbundanordnung zumindest kurzzeitig auszuschalten.

Die Vermeidung einer unnötigen Temperaturbelastung des mit dem rückwärtig beaufschlagten Wafer zu kontaktierenden Wafers wird auch unterstützt durch den Einsatz einer zweiachsig und parallel zur Erstreckungsebene des Wafers wirkenden Positionierungseinrichtung zur Ausrichtung der Kontaktmetallisierungen in einer Überdeckungslage und Ausbildung der Kontaktpaare, da bei exakter Relativpositionierung der Kontaktpaare ein geringstmöglicher Wärmeeintrag in den gegenüberliegenden Wafer zur Herstellung der Kontaktierung notwendig ist. Nachfolgend werden Varianten des erfindungsgemäßen Verfahrens sowie dabei zum Einsatz kommende Vorrichtungsalternativen anhand der Zeichnung beispielhaft erläutert.

Es zeigen:
- **Fig. 1**: eine Vorrichtung zur wechselseitigen Kontaktierung von zwei Wafern in Seitenansicht mit einer unterhalb einer transparenten Platte zur Abstützung und Aufnahme der Wafer angeordneten Diodenlaser-Verbundanordnung;
- **Fig. 2**: eine erste Ausführungsform der in **Fig. 1** dargestellten Vorrichtung mit einer Diodenlaser-Linearanordnung in Draufsicht und in einer Anfangsstellung eines Verfahrweges;
- **Fig. 3**: die in **Fig. 2** dargestellte Diodenlaser-Linearanordnung in einer Mittelstellung des Verfahrweges relativ zum beaufschlagten Wafer;
- **Fig. 4**: eine Ausführungsform der Diodenlaser-Verbundanordnung als Diodenlaser-Matrixanordnung in Draufsicht;
- **Fig. 5**: eine alternative Variante des Verfahrens am Beispiel einer mittels der Verfahrensvariante hergestellten Struktur.

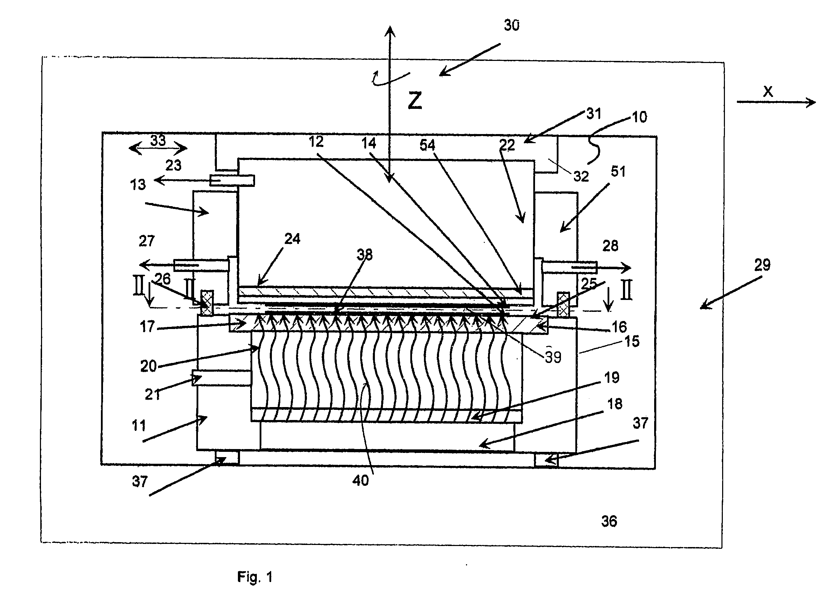

**Fig. 1** zeigt eine Wafer-Kontaktierungsvorrichtung 10 mit einem Aufnahmerahmen 11 zur abstützenden Aufnahme eines ersten, hier als Halbleiter-Wafer 12 ausgeführten Wafers und mit einem Gegenhalter 13 mit einem davon gehaltenen zweiten Wafer, der im vorliegenden Fall als ein Funktionsbauelement-Wafer 14 mit einer Vielzahl darin im Verbund angeordneter Kunststofflinsenteile ausgebildet ist.

Der Aufnahmerahmen 11 besteht aus einem Rahmenzylinder 15, der an seinem oberen Ende einen ringförmigen Absatz 16 aufweist, der zur Aufnahme einer hier als Glasplatte 17 ausgeführten transparenten Platte dient. An seinem der Glasplatte 17 gegenüberliegenden Stirnende ist der Aufnahmerahmen 11 mit einer Diodenlaserverbundanordnung 18 versehen. Oberhalb der Diodenlaserverbundanordnung 18 befindet sich eine Transmissionseinrichtung 19, die von der Diodenlaserverbundanordnung 18 emittierte Laserstrahlung 20 im Wesentlichen absorptionsfrei hindurchtreten lässt und mit zumindest einer hier nicht näher dargestellten Temperatursensoreinrichtung zur Messung einer Referenztemperatur versehen ist. Darüber hinaus ist im Rahmenzylinder 15 umfangsseitig ein Druckanschluss 21 vorgesehen, der eine Beaufschlagung eines zwischen der Glasplatte 17 und der Diodenlaserverbundanordnung 18 bzw. der Transmissionseinrichtung 19 gebildeten Rahmeninnenraums 40 mit Druckluft ermöglicht.

Der im vorliegenden Ausführungsbeispiel ebenfalls einen Rahmenzylinder 51 aufweisende Gegenhalter 13 weist aufgenommen durch den Rahmenzylinder 51 ein druckfestes Gehäuse 22 auf, das mit einem Vakuumanschluss 23 versehen ist. Eine als Gegenhaltefläche 24 dienende Wandung des Gehäuses 22 ist als eine poröse Platte ausgeführt. Der Funktionsbauelement-Wafer 14 wird bei Anlegen eines Vakuums an den Vakuumanschluss 23 gegen die Gegenhaltefläche 24 in der in **Fig. 1** dargestellten Weise gehalten. Bei dem vorliegenden Ausführungsbeispiel ist die poröse Platte mit einer elastischen, porösen Zwischenlage 54 versehen, um lokale Abweichungen in dem zwischen den Kontaktmetallisierungen während der Kontaktierung wirksamen Kontaktdruck ausgleichen zu können.

Wie **Fig. 1** zeigt, wird ein zwischen dem Aufnahmerahmen 11 und dem Gegenhalter 13 gebildeter Prozessraum 25 umfangsseitig durch eine elastische Abdichtung 26 gegenüber der Umgebung abgedichtet. Der Prozessraum 25 ist über Gasanschlüsse 27, 28 mit der Umgebung verbunden. Die Gasanschlüsse 27, 28 ermöglichen das Anlegen eines Vakuums oder beispielsweise auch die Beaufschlagung des Prozessraums 25 mit einem Schutzgas. Eine Vakuumentgasung kann sich beispielsweise beim Einsatz von Klebermaterial als Verbindungsmaterial als vorteilhaft erweisen.

Der Aufnahmerahmen 11 ist zusammen mit dem Gegenhalter 13 in einem umlaufend geschlossenen Maschinenrahmen 29 gehalten. Zur Erzeugung eines zur Kontaktierung von hier nicht näher dargestellten Kontaktmetallisierungen des Halbleiter-Wafers 12 mit Kontaktmetallisierungen des Funktionsbauelement-Wafers 14 notwendigen Kontaktdrucks zwischen den durch jeweils einander gegenüberliegend angeordnete Kontaktmetallisierungen gebildeten Kontaktpaarungen ist zwischen dem Gehäuse 22 und einem Rahmenoberzug 30 des Maschinenrahmens 29 eine Positioniereinrichtung 31 vorgesehen, die einen mit dem Gehäuse 22 verbundenen Gehäuseteil 32 und einen mit dem Rahmenoberzug 30 verbundenen Gehäuseteil 33 aufweist. Neben der zweiachsigen Relativpositionierung des Gehäuseteils 32 gegenüber dem Gehäuseteil 33 um eine senkrecht zur ebenen Erstreckung der Wafer 12, 14 verlaufende Z-Achse und eine parallel zur ebenen Erstreckung der Wafer 12, 14 verlaufende X-Achse 35 ermöglicht die Positioniereinrichtung 31 eine Relativbewegung des Gehäuseteils 32 zum Gehäuseteil 33 in Richtung der Z-Achse und somit eine Zustellbewegung des Funktionsbauelement-Wafers 14 in Richtung auf den Halbleiter-Wafer 12 zur Erzeugung des für die Kontaktierung erforderlichen Kontakt- oder Anpressdrucks.

Zur Kontrolle der Höhe des Anpressdrucks sind über den stirnseitigen Umfang des Aufnahmerahmens 11 verteilt zwischen dem Aufnahmerahmen 11 und einem Rahmenunterzug 36 des Maschinenrahmens 29 Kraftmesszellen 37 angeordnet.

Zur Herstellung der Kontaktierung zwischen den Wafern 12 und 14 wird der Halbleiter-Wafer 12 auf die Glasplatte 17 des Aufnahmerahmens 11 aufgelegt. Die Anlage des Funktionsbauelement-Wafers 14 gegen die Gegenhaltefläche 24 des Gehäuses 22 vom Gegenhalter 13 erfolgt durch Anlegen eines Vakuums an das Gehäuselumen und dem damit verbundenen Ansaugen des Funktionsbauelement-Wafers 14 gegen die als poröse Platte ausgebildete Gegenhaltefläche 24. Nachfolgend erfolgt die exakte Relativpositionierung der Kontaktmetallisierungen auf einer Kontaktoberfläche 38 des Funktionsbauelement-Wafers 14 zu Kontaktmetallisierungen auf einer Kontaktoberfläche 39 des Halbleiter-Wafers 12 durch Ausbildung von Kontaktpaarungen der jeweils einander zugeordneten Kontaktmetallisierungen. Die hierzu erforderliche Ausrichtung erfolgt mittels der Positioniereinrichtung 31 und entsprechender Betätigung von Achsensteuerungen um die Z-Achse und in Richtung der X-Achse.

Die Überwachung der Positionierung kann beispielsweise über ein hier nicht näher dargestelltes optisches Überwachungssystem erfolgen, das in der Lage ist, eine Überdeckung von zumindest zwei voneinander entfernten Kontaktpaarungen zwischen Kontaktmetallisierungen des Halbleiter-Wafers 12 und Kontaktmetallisierungen des Funktionsbauelement-Wafers 14 zu erkennen.

Nach Einstellung der exakten Relativpositionierung wird eine Zustellung des Gegenhalters 13 in Richtung auf den Aufnahmerahmen 11 durch eine Achsensteuerung der Positioniereinrichtung 31 in Richtung der Z-Achse ausgeführt, bis über die Kraftmesszellen 37 das Erreichen des Schwellwertes für den korrekten Anpressdruck erkannt und der entsprechende Achsenantrieb abgeschaltet wird. Zum Ausgleich einer etwaigen Durchbiegung der Glasplatte 17 infolge des Anpressdrucks kann der Innenraum 40 des Aufnahmerahmens 11 über den Druckanschluss 41 mit einem Fluiddruck, also einem Gasdruck oder einem Flüssigkeitsdruck, beaufschlagt werden. Wenn somit sichergestellt ist, dass sämtliche Kontaktpaarungen mit dem zur Kontaktierung erforderlichen Anpressdruck gegeneinander liegen, erfolgt eine Betätigung der Diodenlaserverbundanordnung 18, die je nach Ausführung der Diodenlaserverbundanordnung 18 auf unterschiedliche Art und Weise erfolgen kann.

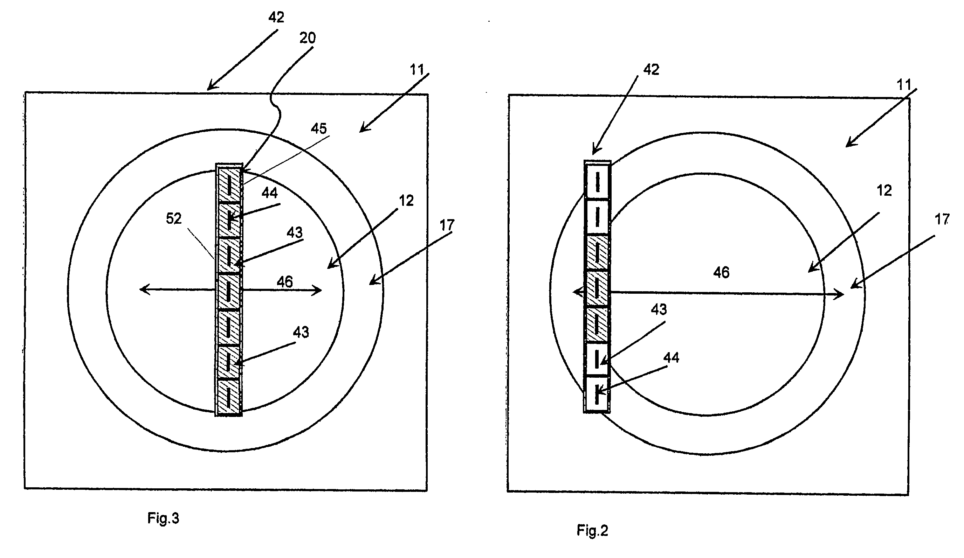

In den Fig. 2 und 3 ist eine Draufsicht auf den Aufnahmerahmen 11 entsprechend dem Schnittlinienverlauf II-II in Fig. 1 dargestellt. Zu erkennen ist der lediglich hinsichtlich seiner Umrisskonturen dargestellte Halbleiter-Wafer 12, der auf der Glasplatte 17 des Aufnahmerahmens 11 angeordnet ist und rückwärtig mittels einer Diodenlaser-Linearanordnung 42 mit Laserstrahlung 20 beaufschlagt wird. Im vorliegenden Fall umfasst die Diodenlaser-Linearanordnung 42 sieben auf einem Diodenlaserträger 52 angeordnete Laserdioden 43, die entsprechend ihrer typischen geschichteten Ausbildung mit einer laseraktiven Schicht jeweils einen näherungsweise im Querschnitt rechteckförmigen Strahlengang 44 emittieren, der zu einer Strahlquerschnittsfläche 45 aufgeweitet, die regelmäßig bis zu mehreren Quadratzentimetern groß ist, rückwärtig auf den Halbleiter-Wafer 12 auftrifft und je nach Anschlussflächendichte des Halbleiter-Wafers 12 eine größere Anzahl von Anschlussflächen gleichzeitig mit Laserstrahlung beaufschlagt.

Die Diodenlaser-Linearanordnung 42 ist mit einer hier nicht näher erläuterten Ansteuerung versehen, die es ermöglicht, die Diodenlaser 43 der Diodenlaser-Linearanordnung 42 einzeln oder gruppenweise zusammengefasst zu aktivieren. Zur rückwärtigen Beaufschlagung der gesamten Kontaktoberfläche des Halbleiter-Wafers 12 wird die Diodenlaser-Linearanordnung 42 ausgehend von der in **Fig. 2** dargestellten Anfangsposition über den gesamten Durchmesser des Halbleiter-Wafers 12 verfahren. Dabei werden jeweils nur diejenigen und so viele Diodenlaser 43 in Abhängigkeit vom Verfahrweg 46 aktiviert, um quer zum Verfahrweg 46 den jeweiligen Durchmesser des Halbleiter-Wafers 12 überdecken zu können. So zeigt im hier dargestellten Ausführungsbeispiel die **Fig. 2** die in der Anfangsposition befindliche Diodenlaser-Linearanordnung 42 mit lediglich drei aktivierten Diodenlasern 43 und die **Fig. 3**, in der eine mittlere Position der Diodenlaser-Linearanordnung 42 längs des Verfahrweges 46 dargestellt ist, eine Aktivierung sämtlicher Diodenlaser 43 der Diodenlaser-Linearanordnung 42.

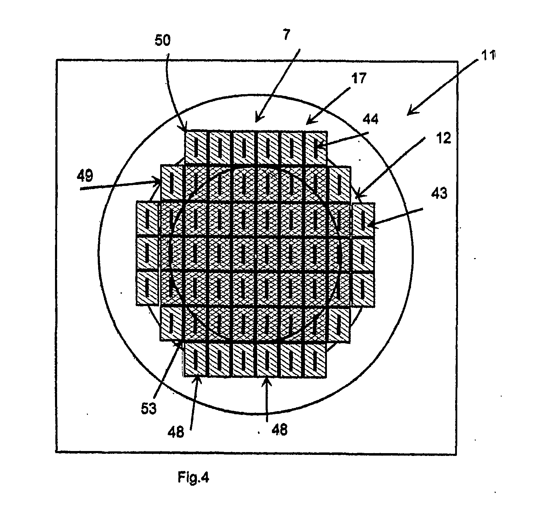

**Fig. 4** zeigt eine Diodenlaser-Matrixanordnung 47 mit zehn Diodenlaser-Spalten 48 und sieben Diodenlaser-Reihen 49. Zur Anpassung an die grundsätzlich kreisflächenförmige Ausbildung des Halbleiter-Wafers 12 und wegen der rechteckförmigen Ausbildung der Strahlquerschnittsfläche 45 ist die Matrix der Diodenlaser-Matrixanordnung 47 unregelmäßig ausgebildet, um die gesamte Kontaktoberfläche 39 des Halbleiter-Wafers 12 mit Laserstrahlung beaufschlagen zu können.

Wie in **Fig. 4** durch die kreuzschraffierte Darstellung eines Teils der Strahlquerschnittsflächen 45 der Diodenlaser 43 verdeutlicht, ist es zur Laserbeaufschlagung eines gegenüber dem Halbleiter-Wafer 12 im Durchmesser reduzierten Halbleiter-Wafers 50 ausreichend, nur einen Teil der Diodenlaser 43 entsprechend einer Teilmatrix 53 zu aktivieren.

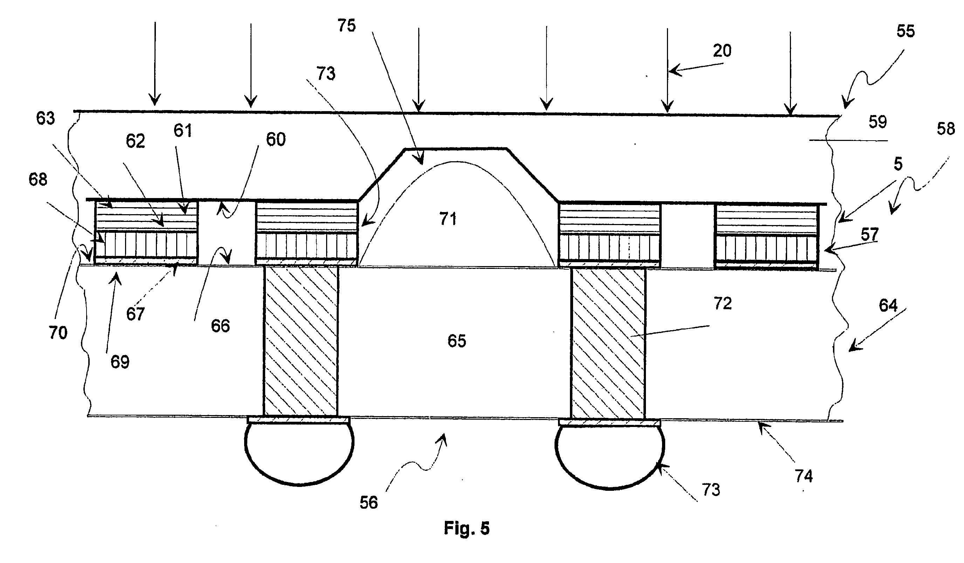

**Fig. 5** zeigt in einem Ausschnitt den Bereich einer in einem Bauteilverbund aus einer Deckeleinheiten-Verbundanordnung 55 und einer Sensoreinheiten-Verbundanordnung 56 hergestellten Sensorchipeinheit 57 einer Sensorchip-Bauteilverbundanordnung 58.

Die Sensorchip-Bauteilverbundanordnung 58 ist mittels der in **Fig. 1** dargestellten Wafer-Kontaktierungsvorrichtung 10 herstellbar.

Zur Herstellung erfolgt die rückwärtige Beaufschlagung von Deckeleinheiten 59, die in der waferartig ausgebildeten Deckeleinheiten-Verbundanordnung 55 zusammenhängend ausgebildet sind. Die Deckeleinheiten 59 weisen im vorliegenden Fall ein transparentes Substratmaterial, wie beispielsweise Glasfritte, auf, das optisch durchlässig ist, und weisen auf ihrer Kontaktoberfläche 60 Kontaktmetallisierungen 61 auf, die im vorliegenden Fall mit einem Lotmaterial als Kontaktmaterial 62, beispielsweise einer Gold-Zinn-Legierung, versehen sind. Zur Erhöhung der Wärmeabsorption in die Kontaktmetallisierungen 61 weisen die Kontaktmetallisierungen 61 eine als Unterschicht ausgebildete, der Laserstrahlung 20 zugewandte Absorptionsschicht 63 auf, die beispielsweise im Wesentlichen Chrom enthalten kann.

Die Sensoreinheiten-Verbundanordnung 56 ist aus einer Vielzahl im zusammenhängenden Verbund ausgebildeten, jeweils einer Deckeleinheit 59 zugeordneten Sensoreinheiten 64 zusammengesetzt. Die Sensoreinheiten 64 weisen im vorliegenden Fall ein Silicium-Substrat 65 auf, das auf seiner der Deckeleinheit 59 zugewandten inneren Kontaktoberfläche 65 mit Kontaktmetallisierungen 67 versehen ist. Die Kontaktmetallisierungen 67 sind im vorliegenden Fall übereinstimmend mit den zugeordneten Kontaktmetallisierungen 61 der Deckeleinheit 59 mit einem Lotmaterial als Kontaktmaterial 68 versehen. Darüber hinaus weisen die Kontaktmetallisierungen 67 im vorliegenden Fall als Unterschicht zum Kontaktmaterial 68 angeordnete Absorptionsschichten 69 auf, die peripher über das Kontaktmaterial 68 hinausragen, derart, dass ein Teil der durch das optisch durchlässige Substratmaterial der Deckeleinheit 59 hindurch gelangten Laserstrahlung 20 in einem peripheren Überstand 70 der Absorptionsschichten 69 absorbiert wird. Durch die vorstehend erläuterte Anordnung und Ausgestaltung der Absorptionsschichten 63 und 69 wird somit ein gleichzeitiger Wärmeeintrag durch Absorption sowohl in die Kontaktmetallisierungen 61 der Deckeleinheit 59 als auch in die Kontaktmetallisierungen 67 der Sensoreinheiten 64 ermöglicht.

Wie ferner aus **Fig. 5** zu ersehen ist, sind die inneren, benachbart einem Sensor 71 der Sensoreinheit 64 angeordneten Kontaktmetallisierungen 67 mit Durchkontaktierungen 72 durch das Substrat 65 versehen, die eine Außenkontaktierung über äußere Kontaktmetallisierungen 73 auf einer äußeren Kontaktoberfläche 74 der Sensoreinheiten 64 ermöglichen. Die dem Sensor 71 benachbarten Kontaktmetallisierungen 67 sind auf hier nicht näher dargestellte Art und Weise mit dem Sensor 71 elektrisch kontaktiert, so dass mittels der Durchkontaktierungen 72 eine äußere Direktkontaktierung des Sensors 71 über die äußeren Kontaktmetallisierungen 73 ermöglicht ist.

Die in **Fig. 5** außen liegenden Kontaktmetallisierungen 61 und 67 sind jeweils ringförmig ausgebildet, so dass nach Kontaktierung ein abgeschlossener Sensoraufnahmeraum 75 gebildet wird, in dem innere Kontaktmetallisierungspaarungen 76 für die elektrische Kontaktierung des Sensors 71 und der Sensor 71 hermetisch abgeschlossen angeordnet sind.

Im Unterschied zu dem vorstehend beschriebenen Ausführungsbeispiel kann das Substratmaterial der Deckeleinheiten 59 auch absorbierend ausgeführt sein, da der temperaturempfindliche Sensor 71 auf den nicht unmittelbar mit Laserstrahlung 20 beaufschlagten Sensoreinheiten 64 angeordnet ist.

## Patentansprüche

1. Verfahren zur wechselseitigen Kontaktierung von zwei waferartigen Bauelement-Verbundanordnungen (12, 14) aus einer Vielzahl zusammenhängend ausgebildeter gleichartiger Bauelemente, insbesondere eines Halbleiter-Wafers mit einem Funktionsbauelement-Wafer, zur Herstellung von elektronischen Baugruppen auf Wafer-Ebene, bei dem die beiden jeweils auf ihren einander gegenüberliegenden Kontaktoberflächen (38, 39) mit Kontaktmetallisierungen versehenen Bauelement-Verbundanordnungen zur Ausbildung von Kontaktpaarungen mit ihren Kontaktmetallisierungen in eine Überdeckungslage gebracht werden, in der die miteinander zu verbindenden Kontaktmetallisierungen gegeneinander gedrückt werden und die Kontaktierung der Kontaktmetallisierungen durch rückwärtige Beaufschlagung der einen Bauelement-Verbundanordnung (12) mit Laserstrahlung (20) erfolgt, wobei die Wellenlänge der Laserstrahlung in Abhängigkeit vom Absorptionsgrad der rückwärtig beaufschlagten Bauelement-Verbundanordnung so gewählt wird, dass eine Transmission der Laserstrahlung durch die rückwärtig beaufschlagte Bauelement-Verbundanordnung im Wesentlichen unterbleibt oder eine Absorption der Laserstrahlung im Wesentlichen in den Kontaktmetallisierungen der einen oder beider Bauelement-Verbundanordnungen erfolgt,
**dadurch gekennzeichnet,**
**dass** die Laserbeaufschlagung mittels einer Verbundanordnung (18, 42, 47) von mehreren Diodenlasern (43) erfolgt, die einzeln oder in Gruppen zusammengefasst zur Emission von Laserstrahlung (20) aktiviert werden, derart, dass sämtliche oder in Gruppen zusammengefasste Kontaktpaarungen zur Kontaktierung mit Laserstrahlung beaufschlagt werden.

2. Verfahren nach Anspruch 1,
**dadurch gekennzeichnet,**
**dass** das Substratmaterial der rückwärtig mit Laserstrahlung beaufschlagten Bauelement-Verbundanordnung (55) so gewählt wird, dass eine Transmission der Laserstrahlung (20) durch die rückwärtig mit Laserstrahlung beaufschlagte Bauelement-Verbundanordnung erfolgt und eine Absorption der Laserstrahlung in den Kontaktmetallisierungen (61) der rückwärtig mit Laserstrahlung beaufschlagten Bauelement-Verbundanordnung erfolgt.

3. Verfahren nach Anspruch 1,
**dadurch gekennzeichnet,**
**dass** das Substratmaterial der rückwärtig mit Laserstrahlung beaufschlagten Bauelement-Verbundanordnung (55) so gewählt wird, dass eine Transmission der Laserstrahlung (20) durch die rückwärtig mit Laserstrahlung beaufschlagte Bauelement-Verbundanordnung erfolgt und eine Absorption der Laserstrahlung in den Kontaktmetallisierungen (61) der rückwärtig mit Laserstrahlung beaufschlagten Bauelement-Verbundanordnung und in den im Vergleich zu den Kontaktmetallisierungen (61) der rückwärtig mit Laserstrahlung beaufschlagten Bauelement-Verbundanordnung (55) flächenmäßigen größeren Kontaktmetallisierungen (67) der gegenüberliegenden Bauelement-Verbundanordnung (56) erfolgt.

4. Verfahren nach einem der vorangehenden Ansprüche,
**dadurch gekennzeichnet,**
**dass** die Diodenlaser-Verbundanordnung als Diodenlaser-Linearanordnung (42) ausgebildet ist, die mit Abstand unterhalb der rückwärtig mit Laserstrahlung (20) beaufschlagten Bauelement-Verbundanordnung (12) angeordnet ist, und dass die Diodenlaser-Linearanordnung zumindest einachsig und parallel zur Erstreckungsebene der Bauelement-Verbundanordnung verfahren wird.

5. Verfahren nach einem der vorangehenden Ansprüche,
**dadurch gekennzeichnet,**
**dass** die Diodenlaser-Verbundanordnung als Diodenlaser-Matrixanordnung (47) ausgebildet ist, wobei die Diodenlaser (43) entsprechend der Größe der rückwärtig mit Laserstrahlung (20) beaufschlagten Bauelement-Verbundanordnung (12) in ihrer Gesamtheit oder nur im Umfang einer Teilmatrix aktiviert werden.

6. Verfahren nach einem der vorangehenden Ansprüche,
**dadurch gekennzeichnet,**
**dass** in einem durch den Abstand ausgebildeten Zwischenraum (40) vermittels einer von der Laserstrahlung (20) durchdrungenen Transmissionseinrichtung (19) eine Referenztemperatur gemessen wird.

7. Verfahren nach einem der vorangehenden Ansprüche,
**dadurch gekennzeichnet,**
**dass** zur Ausrichtung der Kontaktmetallisierungen in einer Überdeckungslage zur Ausbildung der Kontaktpaarungen die der rückwärtig mit Laserstrahlung (20) beaufschlagten Bauelement-Verbundanordnung (12) gegenüberliegende Bauelement-Verbundanordnung (14) mittels einer zweiachsig und parallel zur Erstreckungsebene wirkenden Positioniereinrichtung (31) positioniert wird.

## Claims

1. A method for alternately contacting two wafer-like component composite arrangements (12, 14) consisting of a plurality of cohesively designed similar components, in particular of a semiconductor wafer with a function component wafer for manufacturing electronic modules on a wafer level, in which the two component composite arrangements, each provided with contact metallizations on their opposing contact surfaces (38, 39), are brought into a coverage position with their contact metallizations to form contact pairs, in which position the contact metallizations that are to be joined together are pressed against one another, the contact metallizations being thereby contacted by exposing the rear of one of the component composite arrangements (12) to laser radiation (20), whereby the wavelength of the laser radiation is selected as a function of the degree of absorption of the component composite arrangement exposed to laser radiation at the rear, so that transmission of the laser radiation through the component composite arrangement exposed to the laser radiation at the rear is essentially suppressed or absorption of the laser radiation takes place essentially in the contact metallizations of one or both component composite arrangements.
**characterized in that**
the laser treatment is performed by means of a composite arrangement (18, 42, 47) of a plurality of diode lasers (43) which are activated individually or in groups to emit laser radiation (20) such that all the contact pairs or those combined into groups are exposed to laser radiation for the contacting.

2. The method according to Claim 1,
**characterized in that**
the substrate material of the component composite arrangement (55) that is exposed to laser radiation at the rear is selected so that there is transmission of the laser radiation (20) through the component composite arrangement exposed to the laser radiation at the rear and there is absorption of the laser radiation in the contact metallizations (61) of the component composite arrangement exposed to laser radiation at the rear.

3. The method according to Claim 1,
**characterized in that**
the substrate material of the component composite arrangement (55) exposed to laser radiation at the rear is selected so that there is transmission of the laser radiation (20) through the component composite arrangement exposed to laser radiation at the rear and there is absorption of the laser radiation in the contact metallizations (61) of the component composite arrangement exposed to laser radiation at the rear and in the contact metallizations (67) belonging to the opposing component composite arrangement (56), these contact metallizations having a larger surface area in comparison with the contact metallizations (61) of the component composite arrangement (55) exposed to laser radiation at the rear.

4. The method according to any one of the preceding claims,
**characterized in that**
the diode laser composite arrangement is designed as a diode laser linear arrangement (42) which is arranged at a distance below the component composite arrangement (12) which is exposed to laser radiation (20) at the rear, and the diode laser linear arrangement is moved in at least one axis and in parallel to the plane of extent of the component composite arrangement.

5. The method according to any one of the preceding claims,
**characterized in that**
the diode laser composite arrangement is designed as a diode laser matrix arrangement (47), whereby the diode lasers (43) are activated in their totality or only to the extent of a partial matrix according to the size of the component composite arrangement (12) exposed to laser radiation (20) at the rear.

6. The method according to any one of the preceding claims,
**characterized in that**
a reference temperature is measured in an intermediate space (40) formed by the distance, the measurement being performed by a transmission device (19) through which the laser radiation (20) passes.

7. The method according to any one of the preceding claims,
**characterized in that**
for alignment of the contact metallizations in a coverage position to form the contact pairs, the component composite arrangement (14) opposite the component composite arrangement (12) exposed to laser radiation (20) at the rear is positioned by means of a positioning device (31) which acts biaxially and in parallel to the plane of extent.

## Revendications

1. Procédé pour mettre en contact alternatif deux agencements composites de composants (12, 14) d'une pluralité de composants similaires formés cohérents, en particulier d'une tranche de semiconducteur avec une tranche de composant fonctionnel, pour fabriquer des modules électroniques à base de tranche, les agencements composites de composants pourvus de métallisations de contact sur leurs surfaces de contact (38, 39) opposées étant positionnés avec leurs métallisations de contact dans une position de recouvrement pour former des paires de contact, les métallisations de contact qu'il faut connecter entre elles étant pressées l'une contre l'autre dans ladite position, et la mise en contact des métallisations de contact s'effectuant au moyen d'une application de rayonnement laser (20) par l'arrière à un des agencements composites de composants (12), la longueur d'onde du rayonnement laser étant choisie en fonction du degré d'absorption de l'agencement composite de composants exposé au rayonnement laser par l'arrière de telle manière qu'une transmission du rayonnement laser à travers l'agencement composite de composants exposé au rayonnement laser par l'arrière soit essentiellement empêchée ou bien une absorption du rayonnement laser ait lieu essentiellement dans les métallisations de contact de l'un ou des deux agencements composites de composants,
**caractérisé en ce que**
l'application du rayonnement laser s'effectue au moyen d'un agencement composite (18, 42, 27) de plusieurs diodes laser (43) qui sont activées individuellement ou de manière réunie en groupe, de telle manière que toutes les paires de contact ou des paires de contact réunies en groupe soient exposées au rayonnement laser en vue d'une mise en contact.

2. Procédé selon la revendication 1,
**caractérisé en ce que**
le matériel de substrat de l'agencement composite de composants (55) exposé au rayonnement laser par l'arrière est choisi de telle manière qu'une transmission du rayonnement laser (20) s'effectue à travers l'agencement composite de composants exposé au rayonnement laser par l'arrière et une absorption du rayonnement laser ait lieu dans les métallisations de contact (61) de l'agencement composite de composants exposé au rayonnement laser par l'arrière.

3. Procédé selon la revendication 1,
**caractérisé en ce que**
le matériel de substrat de l'agencement composite de composants (55) exposé au rayonnement laser par l'arrière est choisi de telle manière qu'une transmission du rayonnement laser (20) s'effectue à travers l'agencement composite de composants exposé au rayonnement laser par l'arrière et une absorption du rayonnement laser ait lieu dans les métallisations de contact (61) de l'agencement composite de composants exposé au rayonnement laser par l'arrière et dans les métallisations de contact (67) de l'agencement composite de composants (56) opposé qui ont une étendue plus grande par rapport aux métallisations de contact (61) de l'agencement composite de composants (55) exposé au rayonnement laser par l'arrière.

4. Procédé selon l'une quelconque des revendications précédentes,
**caractérisé en ce que**
l'agencement composite de diodes laser est réalisé comme agencement linéaire de diodes laser (42) qui est arrangé à une distance au-dessous de l'agencement composite de composants (12) exposé au rayonnement laser (20) par l'arrière et que l'agencement linéaire de diodes laser est déplacé sur au moins un axe et parallèlement au plan d'étendue de l'agencement composite de composants.

5. Procédé selon l'une quelconque des revendications précédentes,
**caractérisé en ce que**
l'agencement composite de diodes laser est réalisé comme agencement matriciel de diodes laser (47), dans lequel les diodes laser (43) sont activées dans leur intégralité ou seulement dans la mesure d'une matrice partielle, correspondant à la grandeur de l'agencement composite de composants (12) exposé au rayonnement laser (20) par l'arrière.

6. Procédé selon l'une quelconque des revendications précédentes,
**caractérisé en ce que**
dans un espace intermédiaire (40) formé par la distance une température de référence est mesurée au moyen d'un dispositif de transmission (19) traversé par le rayonnement laser (20).

7. Procédé selon l'une quelconque des revendications précédentes,
**caractérisé en ce que**
pour ajuster les métallisations de contact dans une position de recouvrement pour former les paires de contact l'agencement composite de composants (14) arrangé en sens opposé de l'agencement composite de composants (12) exposé au rayonnement laser (20) par l'arrière est positionné au moyen d'un dispositif de positionnement (31) agissant de manière biaxe et parallèlement au plan d'étendue.
